Europäisches Patentamt

European Patent Office

Office européen des brevets

(11) Veröffentlichungsnummer: **0 181 492**
**B1**

(12) **EUROPÄISCHE PATENTSCHRIFT**

(45) Veröffentlichungstag der Patentschrift: **09.01.91**

(21) Anmeldenummer: **85112739.9**

(22) Anmeldetag: **08.10.85**

(51) Int. Cl.⁵: **H 05 K 7/18,** H 05 K 7/14,
H 01 R 23/70, H 01 R 23/72

(54) Zentrierleiste zum Aufstecken auf eine Rückwandleiterplatte.

(30) Priorität: **12.11.84 DE 3441301**

(43) Veröffentlichungstag der Anmeldung:
**21.05.86 Patentblatt 86/21**

(45) Bekanntmachung des Hinweises auf die
Patenterteilung:
**09.01.91 Patentblatt 91/02**

(84) Benannte Vertragsstaaten:
**CH DE FR GB IT LI SE**

(56) Entgegenhaltungen:
**DE-B-2 006 465**
**GB-A-1 237 406**
**US-A-3 866 997**
**US-A-4 286 837**

(73) Patentinhaber: **Siemens Aktiengesellschaft**
**Wittelsbacherplatz 2**
**D-8000 München 2 (DE)**

(72) Erfinder: **Glomb, Kurt, Dipl.-Ing. (FH)**
**Nelkenstrasse 11**
**D-8034 Germering (DE)**
Erfinder: **Niggl, Heinz, Ing. (grad.)**
**Lindenberg 149**
**D-8134 Pöcking (DE)**
Erfinder: **Pelzl, Leo, Dipl.-Ing. (FH)**
**Alpenblickstrasse 5**
**D-8150 Holzkirchen (DE)**
Erfinder: **Zell, Karl, Dipl.-Ing. (FH)**
**Moritz -von-Schwind-Weg 80**
**D-8134 Niederpöcking (DE)**

Courier Press, Leamington Spa, England.

## Beschreibung

Die Erfindung betrifft eine Zentrierleiste zum Aufstecken auf eine mit Kontaktmessern versehene Rückwandleiterplatte, wobei die zur Aufnahme von Federleisten dienende Zentrierleiste als einseitig offenes rechtwinkliges Gehäuse ausgebildet ist.

Derartige Zentrierleisten werden gleichzeitig auf mehrere Reihen von Kontaktmessern der Rückwandleiterplatte aufgesteckt. Sind die Kontaktmesserreihen auf der Rückwandleiterplatte nun derart verteilt, daß zwischen den Zentrierleisten Freiräume entstehen, so stellt das Aufstecken und das Abziehen der einzelnen Zentrierleisten kein Problem dar. Ist dagegen die Aufteilung der Kontaktmesser auf der Rückwandleiterplatte derart, daß die Zentrierleisten ohne Zwischenraum nebeneinander aufgesteckt werden können, so stellt das Aufstecken der Zentrierleisten kein Problem dar. Problematisch ist dagegen in diesem Falle daß Abziehen der Zentrierleisten im Bedarfsfalle, z.B. zu Raparaturzwecken, von den Kontaktmessern.

Aufgabe der vorliegenden Erfindung ist es, eine Zentrierleiste der eingangs genannten Art anzugeben, die auch dann leicht abziehbar ist, wenn mehrere Zentrierleisten ohne Zwischenraum nebeneinander auf eine Rückwandleiterplatte aufsteckbar sind.

Diese Aufgabe wird erfindungsgemäß für eine Zentrierleiste der oben angegebenen Art dadurch gelöst, daß in vorgegebenen Abständen in den Seitenwänden sich jeweils gegenüberliegende Ausschnitte vorgesehen sind.

Auf diese Weise ist es möglich, Haken eines beliebig gestalteten Abziehwerkzeuges in die Seitenwände der Messerleiste anzuhängen, wobei die Haken von innen in die Ausschnitte der Seitenwände eingreifen. So ist es möglich, einzelne Zentrierleisten von mehreren direkt nebeneinander auf eine Rückwandleiterplatte aufgesteckten Zentrierleisten ohne großen Aufwand im Bedarfsfalle abzuziehen.

Eine Weiterbildung der erfindungsgemäßen Zentrierleiste ist dadurch gekennzeichnet, daß die Ausschnitte jeweils in der unterer Hälfte der Seitenwande vorgesehen sind. Dadurch wird die beim Abziehen benötigte Kraft auf größere Flächen der Seitenwände verteilt.

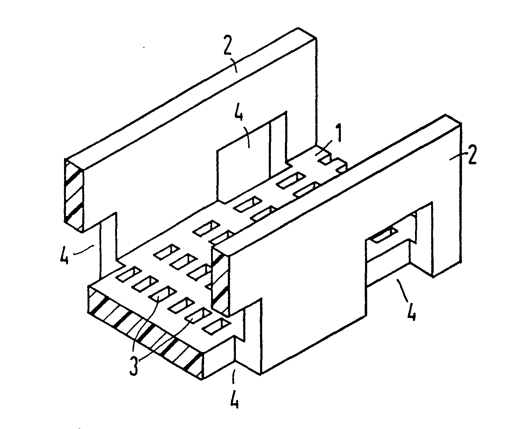

Nachfolgend wird die Erfindung anhand eines in der Zeichnung dargestellten Ausführungsbeispieles näher beschrieben.

Die Zeichnung zeigt in perspektivischer Darstellung ein Teil einer Zentrierleiste, die gemäß der Erfindung aufgebaut ist. Die teilweise dargestellt Zentrierleiste wird auf eine mit eingesetzten Kontaktmessern bestückte Rückwandleiterplatte aufgesteckt und dient zur Aufnahme von Federleisten, die mit elektrischen Baugruppen fest verbunden sind. Beim Aufstecken der Zentrierleiste auf eine mit Kontaktmessern bestückte Rückwandleiterplatte treten die Kontaktmesser durch die Durchtrittsöffnungen 3 im Boden 1 der Zentrierleiste. Seitlich wird die dargestellte Zentrierleiste durch die Seitenwände 2 begrenzt. Diese Seitenwände 2 weisen in vorgegebenen Abständen Ausschnitte 4 auf, wobei jeweils ein Ausschnitt 4 einer Seitenwand 2 einem Ausschnitt 4 der anderen Seitenwand 2 gegenüberliegt.

Diese Ausschnitte 4 dienen dazu, für den Fall, daß die einzelnen Zentrierleisten direkt nebeneinander auf eine Rückwandleiterplatte aufgesteckt sind, daß Ansetzen eines Abzeihwerkzeuges zu ermöglichen. Dabei können Teile eines Abziehwerkzeuges vom Inneren der Zentrierleiste in die Ausschnitte 4 eingreifen, wodurch ein leichtes Abziehen der Zentrierleisten ermöglicht wird. Aus die Darstellung eines Abziehwerkzeuges wird in diesen Zusammenhang verzichtet, da dessen Ausgestaltung beliebig sein kann und nicht erfindungswesentlich ist.

## Patentansprüche

1. Zentrierleiste zum Aufstecken auf eine mit Kontaktmessern versehene Rückwandleiterplatte, wobei die zur Aufnahme von Federleisten dienende Zentrierleiste als einseitig offenes rechtwinkliges Gehäuse ausgebildet ist, dadurch gekennzeichnet, daß in vorgegebenen Abständen in den Seitenwänden (2) sich jeweils gegenüberliegende Ausschnitte (4) vorgesehen sind.

2. Zentrierleiste nach Anspruch 1, dadurch gekennzeichnet, daß die Ausschnitte (4) jeweils in der unteren Hälfte der Seitenwände (2) vorgesehen sind.

## Revendications

1. Réglette de centrage, destinée à être enfichée sur une plaquette à circuits imprimés arrière et munie de lames de contact, la réglette de centrage, servant à la réception de connecteurs à ressort, étant constituée sous la forme d'un boîtier rectangulaire ouvert d'un côé, caractérisé en ce qu'il est prévu des découpures (4) opposées à des distances prescrites dans les parois latérales (2).

2. Réglette de centrage suivant la revendication 1, caractérisé en ce que les découpures (4) sont prévues dans les moitiés inférieures des parois latérales (2).

## Claims

1. Centering strip for plugging onto a backplane printed circuit board provided with contact blades, the centering strip serving for the acceptance of multiple contact strips being fashioned as a rectangular housing open on one side, characterized in that cutouts (4) lying opposite one another are provided in the side walls (2) at predetermined intervals.

2. Centering strip according to Claim 1, characterized in that the cutouts (4) are in each case provided in the lower half of the side walls (2).